# EUROPÄISCHE PATENTANMELDUNG

(11) **EP 0 877 485 A1**
(43) Veröffentlichungstag der Anmeldung: **11.11.1998**
(21) Anmeldenummer: 98108198.7
(22) Anmeldetag: 06.05.1998
(51) Int. Cl.: H03K 17/725

(54) **Zündschaltung eines Triacs**

(30) Priorität: 10.05.1997 DE 19719786
(71) Anmelder: AKO-Werke GmbH & Co. KG, 88239 Wangen (DE)
(72) Erfinder: Simon, Helmut, Dipl.-Ing., 88260 Ratzenried (DE); Burth, Reinhold, Dipl.-Ing. (FH), 88239 Wangen/Allgäu (DE)
(74) Vertreter: Hofmann, Gerhard, Dipl.-Ing. Patentassessor

(57) **Zusammenfassung**

Bei einer Zündschaltung eines Triacs (2), der eine induktive Last, insbesondere einen Motor einer Wäschetrommel in Phasenanschnittsteuerung mittels eines Mikrorechners (5) steuert, ist zur Spannungsversorgung des Mikrorechners (5) und eines Zündverstärkers (3) ein Netzteil (6) vorgesehen. Um trotz sicheren Zündens den Zündstromverbrauch gering zu halten und damit das Netzteil (6) preisgünstig aufbauen zu können, ist an einen Analogeingang (10) des Mikrorechners (5) ein der am Triac (2) abfallenden Spannung entsprechendes Spannungssignal gelegt. Ein Zündimpuls wird vom Mikrorechner (5) dann ausgelöst, wenn das Spannungssignal außerhalb eines Spannungsbereiches liegt, in dem es bei durchgeschaltetem Triac (2) liegt.

## Beschreibung

Die Erfindung betrifft eine Zündschaltung eines Triacs, der eine induktive Last steuert, beispielsweise einen Motor für Haushaltsgeräte, wie Waschmaschinen oder dergleichen, nach dem Oberbegriff von Patentanspruch 1.

Induktive Lasten, insbesondere Wäschetrommelmotoren, werden gewöhnlich durch einen Triac angesteuert. Nach der EP 0 695 982 A1 ist zur Ansteuerung eine Steuerelektronik mit einem Mikroprozessor vorgesehen, wobei der Mikroprozessor auch der Steuerung weiterer Funktionen der Waschmaschine oder des Wäschetrockners dient. Für die Versorgung der Steuerelektronik und des Mikroprozessors, bzw. Mikrocontrollers, ist ein Netzteil erforderlich.

Die Regelung, insbesondere Drehzahlregelung der induktiven Last, erfolgt gewöhnlich durch Phasenanschnittsteuerung des Triacs, wobei der Zündzeitpunkt (Zündwinkel) auf die Phasenlage der Netzspannung bezogen ist. Wegen der bei induktiven Lasten auftretenden Phasenverschiebung zwischen Strom und Spannung kann es dazu kommen, daß der von einem ersten Zündimpuls gezündete Triac im nacheilenden Stromnulldurchgang wieder erlischt, weil der Mindest-Haltestrom des Triacs noch nicht erreicht wird. Dies ist unerwünscht, weil dadurch die Ansteuerung der induktiven Last gestört wird.

Um das unerwünschte Erlöschen, also Sperren, des Triacs zu beheben, wird nach dem Stand der Technik eine Serie von Nachtriggerimpulsen erzeugt, wobei die Nachtriggerimpulse gleiche Zeitabstände, beispielsweise 0,5 ms, bei einer Impulsdauer von 0,05 ms haben.

Nachteilig bei dieser Lösung ist der vergleichsweise hohe Zündstrombedarf. Dieser bedingt, daß das den Mikrorechner (Mikroprozessor bzw. Mikrocontroller) und den Zündverstärker versorgende Netzteil so dimensioniert sein muß, daß es den hohen Zündstrombedarf deckt, ohne daß die Versorgungsspannung zusammenbricht.

Aufgabe der Erfindung ist es, eine Schaltung der eingangs genannten Art vorzuschlagen, bei der trotz sicherer Zündung des Triacs der Zündstromverbrauch gering ist, um das Netzteil preisgünstig aufbauen zu können.

Erfindungsgemäß ist obige Aufgabe durch die Merkmale des kennzeichnenden Teils des Anspruchs 1 gelöst. Dadurch ist erreicht, daß Zündimpulse nur dann auftreten, wenn sie tatsächlich nötig sind. Durch diese Verringerung der ausgelösten Zündimpulse ist der Zündstromverbrauch, den das Netzteil decken muß, beträchtlich reduziert.

Für die Schaltung selbst ist der Mehraufwand gegenüber den Ersparnissen am Netzteil gering, da der Mikrorechner oder Mikrocomputer ohnehin vorgesehen ist und ihm nur eine zusätzliche Funktion übertragen wird.

Vorteilhafte Ausgestaltungen der Erfindung ergeben sich aus den Unteransprüchen und der folgenden Beschreibung eines Ausführungsbeispieles. In der Zeichnung zeigen:

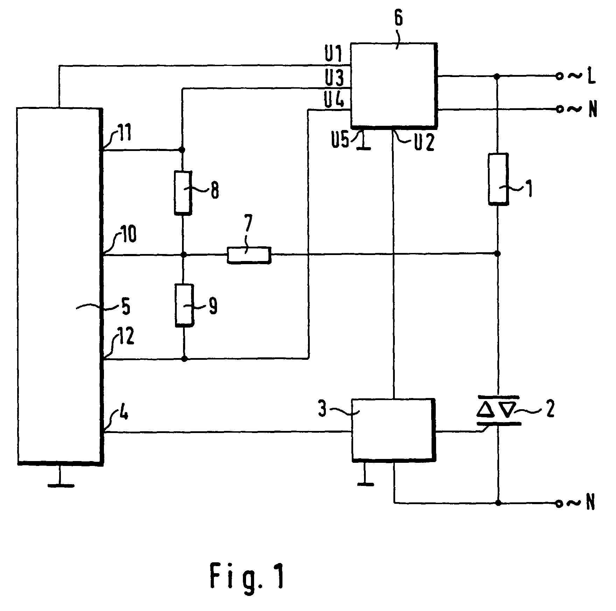

- Figur 1: ein schematisches Schaltbild der Zündschaltung,
- Figur 2: ein Strom-Spannungsdiagramm der Schaltung,
- Figur 3: ein Strom-Spannungsdiagramm der Schaltung bei 100 % Ansteuerung (0° Zündwinkel) und induktiver Last,
- Figur 4: ein gegenüber Figur 3 zeitgespreiztes Strom-Spannungsdiagramm und
- Figur 5: zum Vergleich ein Strom-Spannungsdiagramm nach dem Stand der Technik.

Ein Motor einer Waschmaschine oder eines Wäschetrockners, beispielsweise für den Antrieb einer Wäschetrommel, ist ein Universalmotor und stellt eine induktive Last 1 dar, die über einem Triac 2 am Haushaltsnetz L, N liegt. Der Triac 2 ist über einen Zündverstärker 3 von einem Ausgang 4 eines Mikrorechners 5 ansteuerbar. Der Mikrorechner 5 generiert Zündimpulse zur Drehzahlsteuerung oder -regelung des Motors 1 durch eine auf die Netzphase bezogene Phasenanschnittsteuerung. Diese Zündimpulse werden von dem Zündverstärker 3 auf eine für den Triac 2 geeignete Amplitude verstärkt.

Ein an der Netzspannung L, N liegendes Netzteil 6 hat einen Ausgang U₁ zur Versorgung des Mikrorechners 5 und einen Ausgang U₂ zur Versorgung des Zündverstärkers 3.

Der lastseitige Anschluß des Triacs 2 liegt über einem spannungsfesten Widerstand 7 am Mittelpunkt eines Spannungsteilers aus Widerständen 8, 9 und an einem Analogeingang 10 des Mikrorechners 5. Die Widerstände 8, 9 sind an Referenzspannungseingänge 11, 12 des in dem Mikrorechners 5 integrierten Analogwandlers gelegt.

Die Widerstände 7, 8, 9 sind so dimensioniert, daß sich bei durchgeschaltetem, gezündetem Triac 2 eine Spannung am Analogeingang 10 ergibt, die sich eindeutig von denjenigen Spannungen unterscheidet, welche sich in der positiven und der negativen Halbwelle der Netzspannung bei nicht durchgeschaltetem Triac 2 ergeben. Vorzugsweise ist die Spannung am Analogeingang 10 bei durchgeschaltetem Triac 2 gleich der halben Spannung zwischen den Referenzspannungseingängen 11, 12. Der zu erwartende Maximalwert bei nicht durchgeschaltetem Triac 2 liegt unterhalb der positiven Referenzspannung U₃ am Referenzspannungseingang 11. Der zu erwartende Minimalwert bei nicht durchgeschaltetem Triac 2 liegt oberhalb der negativen Referenzspannung U₄ am Referenzspannungseingang 12. Die positive Referenzspannung U₃ kann ein gleiches Spannungspotential wie der Ausgang U₁ des Netzteils 6, und die negative Referenzspannung kann ein gleiches Spannungspotential wie der Bezugspunkt U₅ besitzen.

Der Mikrorechner 5 wertete, bevor er einen Zündimpuls (Nachtriggerimpuls) erzeugt, die am Analogeingang 10 anstehende Spannung aus. Ein den Triac 2 über den Zündverstärker 3 zündender Triggerimpuls wird nur erzeugt, wenn am Analogeingang 10 eine Spannung anliegt, die außerhalb eines Bereichs um diejenige Spannung herum liegt, die sich bei durchgezündetem Triac 2 ergibt.

Das Netzteil 6 kann beispielsweise ein einfach aufgebautes Kondensatornetzteil mit einem Vorwiderstand und einem Kondensator sein.

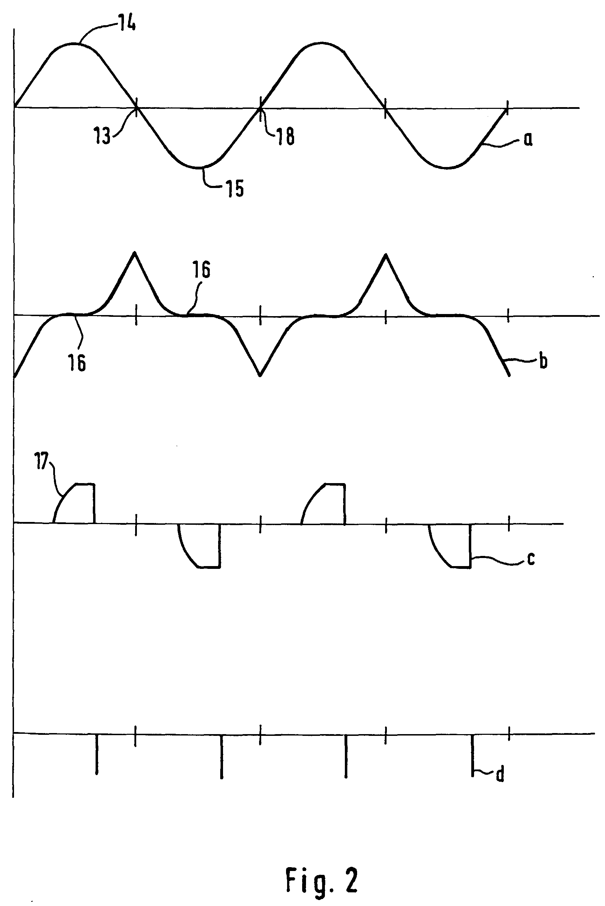

In den Zeitdiagrammen der Figuren 2 bis 5 zeigen die Kurve a die Netzspannung, die Kurve b den durch die induktive Last 1 bzw. den Triac 2 fließenden Strom, die Kurve c die Spannung über den Triac 2 und die Kurve d Zündimpulse bzw. Nachtriggerimpulse.

Nach dem Beispiel in Figur 2 wird der Zündimpuls nach dem Durchgang 13 der Netzspannung durch das positive Maximum 14 erzeugt, um den Motor 1 in Teillast zu betreiben. Beim Stromnulldurchgang 16 geht der Triac 2 in seinen Sperrzustand über und die an ihm abfallende Spannung 17 steigt. Beim nächsten Zündimpuls nach dem Durchgang der Netzspannung durch das negative Maximum 15 wird der Triac 2 wieder gezündet. Bei diesem Betriebsbeispiel liegt nach jedem Zündimpuls die Spannung am Analogeingang 10 innerhalb eines Bereiches an, und zwar um diejenige Spannung, die sich ergibt, wenn der Triac gezündet ist. Der Triac 2 rastet ein, d.h. bleibt bis zum nächsten Spannungsnulldurchgang 18 gezündet. Der Mikrorechner 5 löst nach dem Zündimpuls keine Nachtriggerimpulse aus, weil diese überflüssig wären. Das Netzteil 6 wird also nicht durch die Erzeugung von Nachtriggerimpulsen belastet.

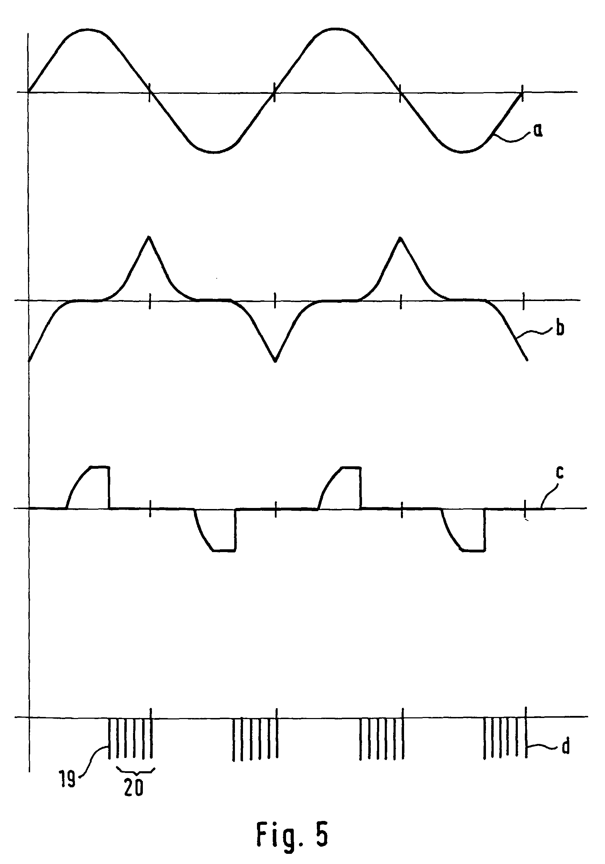

Figur 5 zeigt die gleichen Verhältnisse wie Figur 2. Nach dem Stand der Technik, den Figur 5 zeigt, werden jedoch nach dem jeweils ersten Zündimpuls 19 Nachtriggerimpulse 20 erzeugt, wie dies die Kurve d offenbart. Überschlagsrechnungen zeigen, daß bei einem Impulsabstand von 0,5 ms, einer Impulslänge von 0,05 ms und einer Impulsamplitude von 100 mA der Stromverbrauch nach dem Stand der Technik etwa um den Faktor 6 höher ist als bei der Erfindung. Dementsprechend muß beim Stand der Technik ein größerer und damit teuerer Kondensator im Netzteil, beispielsweise 0,001 mF, als bei der Erfindung, beispielsweise 0,00047 mF, verwendet werden.

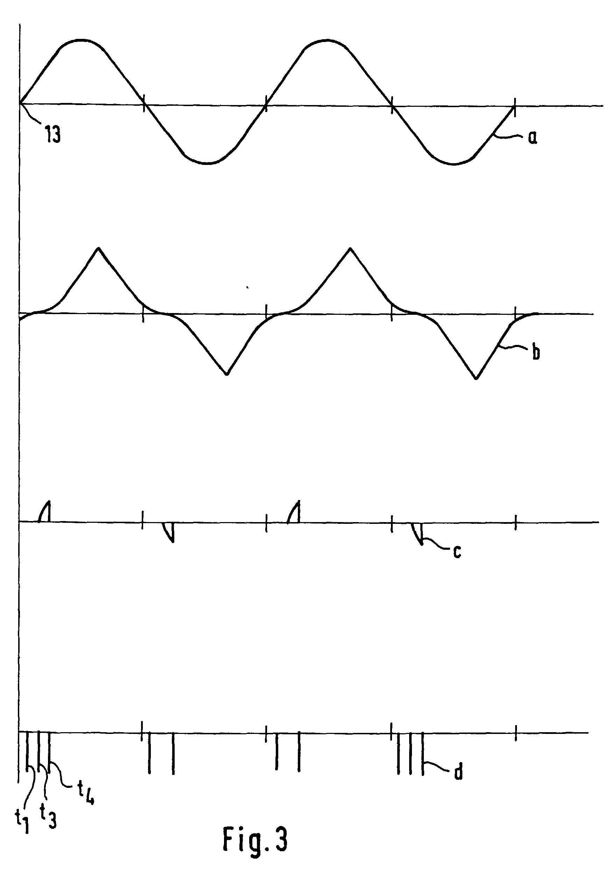

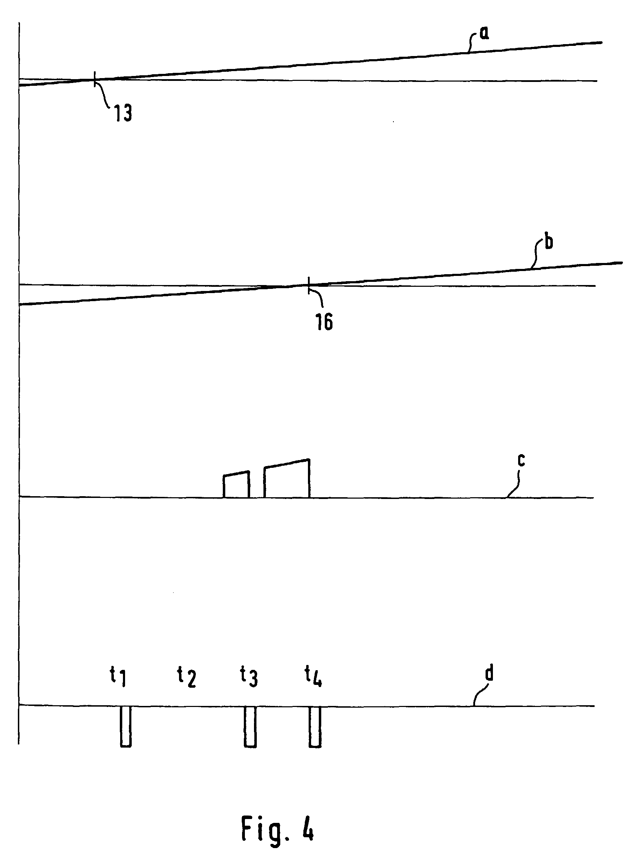

In den Figuren 3 und 4 ist der Fall gezeigt, in dem eine 100%-Ansteuerung des Motors 1 gewünscht ist. Dementsprechend erzeugt der Mikrorechner 5 den ersten Zündimpuls im Zeitpunkt t₁ gleich nach dem Nulldurchgang 13 der Netzspannung (Kurve a). Wegen der Phasenverschiebung aufgrund der induktiven Last 1 ist zum Zeitpunkt t₁ der Triac 2 noch aus der vorhergehenden Periode gezündet. Dieser erste Zündimpuls ist ein Sonderfall und könnte also an sich als überflüssig betrachtet werden und deshalb entfallen. Er kann jedoch für die Ansteuersicherheit und wegen der möglichen unterschiedlichen Phasenverschiebung an den Triac gegeben werden. Im Regelfall wird der Zündimpuls t₁ nicht erzeugt, weil der Triac 2 noch gezündet ist.

Der Mikrorechner 5 ist im Prinzip fähig, in gleichen Zeitabständen, beispielsweise 0,5 ms, Nachtriggerimpulse über den Zündverstärker 3 an den Triac 2 zu legen. Zum Zeitpunkt t₂, zu dem der Mikrorechner 5 bereit ist, den ersten Nachtriggerimpuls zu erzeugen, wird dieser beim Betriebsbeispiel der Figuren 3 und 4 nicht an den Zündverstärker 3 und damit auch nicht an den Triac 2 gegeben, weil die am Triac 2 abfallende Spannung (Kurve c) noch 0 V ist, d.h. die Spannung am Analogeingang 10 liegt im Bereich derjenigen Spannung, die sich bei gezündetem Triac 2 ergibt.

Im Zeitpunkt t₃ des nächsten Nachtriggerimpulses ist der Nulldurchgang des Stromes (Kurve b) erreicht und die am Triac 2 abfallende Spannung steigt an. Die Spannung am Analogeingang 10 liegt nun außerhalb eines Bereiches um diejenige Spannung, die sich bei durchgezündetem Triac 2 ergibt. Der Mikrorechner 5 gibt also einen Nachtriggerimpuls über den Zündverstärker 3 an den Triac 2. Dieser Nachtriggerimpuls bringt die am Triac 2 abfallende Spannung zum Zusammenbrechen. Der Triac 2 zündet zwar zunächst, erlischt jedoch wieder, da wegen der kleinen Netzspannung der entstehende Strom noch kleiner als der für den Triac 2 nötige Mindest-Haltestrom ist. Die Spannung am Analogeingang 10 liegt außerhalb des Bereiches derjenigen Spannung, die sich bei durchgezündetem Triac 2 ergibt.

Im nachfolgenden Zeitpunkt t₄ tritt der dritte Nachtriggerimpuls auf, weil die Spannung am Analogeingang 10 außerhalb des genannten Bereiches liegt. Der Triac 2 wird gezündet und bleibt gezündet, weil sein Mindest-Haltestrom aufgrund der nunmehr in der Netzhalbwelle angestiegenen Spannung erreicht ist. Weitere Nachtriggerimpulse treten nicht mehr auf, weil der Mikrorechner 5 an seinem Analogeingang 10 erkennt, daß der Triac 2 gezündet ist.

In der nächsten Netzspannungshalbwelle wiederholen sich die beschriebenen Vorgänge.

Die Maximalanzahl der für eine sichere Zündung des Triacs 2 in jeder Netzhalbwelle nötigen Zündimpulse ist also gering und liegt etwa bei 1 bis 2 Zündimpulsen. Es ist auch nicht zu befürchten, daß die vom Netzteil 6 abgegebene Versorgungsspannung zusammenbricht. Hierfür kann es günstig sein, durch einen Algorithmus des Mikrorechners 5 die innerhalb einer bestimmten Zeitspanne maximal auszulösenden Zünd- bzw. Nachtriggerimpulse auf eine bestimmte Zahl, beispielsweise 2 bis 4 pro Netzhalbwelle, zu beschränken. Damit ist vermieden, daß in einem etwaigen Fehlerfall, beispielsweise beim unerwünschten Abheben von Bürsten des Motors 1, derart viele Zündimpulse erzeugt werden, daß dadurch das Netzteil 6 überlastet würde.

## Patentansprüche

1. Zündschaltung eines Triacs, der eine induktive Last, insbesondere einen Motor für Haushaltsgeräte, in Phasenanschnittsteuerung mittels eines Mikrorechners steuert, wobei zur Spannungsversorgung des Mikrorechners und eines Zündverstärkers für den Triac ein Netzteil vorgesehen ist,
dadurch gekennzeichnet,
daß an einen Analogeingang (10) des Mikrorechners (5) ein Spannungssignal gelegt ist, das der an dem Triac (2) abfallenden Spannung entspricht, und daß ein Zündimpuls oder Nachtriggerimpuls vom Mikrorechner (5) dann ausgelöst wird, wenn das Spannungssignal außerhalb eines Spannungsbereiches liegt, in dem das Spannungssignal bei durchgeschaltetem Triac (2) liegt.

2. Zündschaltung nach Anspruch 1,
dadurch gekennzeichnet,
daß der Mikrorechner (5) in jeder Netzhalbwelle entsprechend des zur Ansteuerung des Triacs (2) vorgesehenen Zündwinkels einen Zündimpuls erzeugt und ausgelegt ist, nach dem Zündimpuls Nachtriggerimpulse in gleichen zeitlichen Abständen auslösen zu können und Nachtriggerimpulse unterdrückt, wenn das Spannungssignal am Analogeingang (10) innerhalb eines Bereiches um diejenige Spannung liegt, die sich bei durchgeschaltetem Triac (2) ergibt.

3. Zündschaltung nach Anspruch 1 oder 2,
dadurch gekennzeichnet,
daß der Triac (2) lastseitig über einen Widerstand (7) an den Analogeingang (10) und einen Spannungsteiler (8,9) gelegt ist.

4. Zündschaltung nach Anspruch 3,
dadurch gekennzeichnet,
daß der Spannungsteiler (8,9) an Referenzspannungseingänge (11,12) des Mikrorechners (5) gelegt ist.

5. Zündschaltung nach einem der vorhergehenden Ansprüche,
dadurch gekennzeichnet,
daß der lastseitige Widerstand (7) und die Widerstände (8,9) des Spannungsteilers so dimensioniert sind, daß sich das bei durchgeschaltetem Triac (2) am Analogeingang (10) ergebende Spannungssignal eindeutig von den Spannungen unterscheidet, die sich in den positiven und negativen Halbwellen bei nicht durchgeschaltetem Triac 2 ergeben.

6. Zündschaltung nach Anspruch 5,
dadurch gekennzeichnet, daß das Spannungssignal am Analogeingang (10) bei durchgeschaltetem Triac (2) etwa gleich der halben Spannung zwischen den Referenzspannungseingängen (11,12) ist, und daß der bei nicht durchgeschaltetem Triac (2) am Analogeingang (10) zu erwartende Maximalwert unterhalb der positiven Referenzspannung (U₃) am Referenzspannungseingang (11) und der zu erwartende Minimalwert oberhalb der negativen Referenzspannung (U₄) am Referenzspannungseingang (12) liegen.

7. Zündschaltung nach einem der vorhergehenden Ansprüche,
dadurch gekennzeichnet,
daß der Mikrorechner (5) die Anzahl der innerhalb einer festgelegten Zeitspanne, beispielsweise Netzhalbwelle, maximal ausgelösten Zünd- oder Nachtriggerimpulse begrenzt.

8. Zündschaltung nach einem der vorhergehenden Ansprüche,
dadurch gekennzeichnet,
daß der Mikrorechner (5) von einer positiven Versorgungsspannung und der Zündverstärker (3) von einer negativen Versorgungsspannung des Netzteils (6) gespeist ist.
